# EUROPÄISCHE PATENTANMELDUNG

(11) **EP 1 316 810 A2**
(43) Veröffentlichungstag der Anmeldung: **04.06.2003**
(21) Anmeldenummer: 02024796.1
(22) Anmeldetag: 07.11.2002
(51) Int. Cl.: G01R 33/561

(54) **Verfahren zur Messung der Magnetresonanz (NMR) mittels Spin-Echos**

(30) Priorität: 29.11.2001 DE 10158531
(71) Anmelder: Universitätsklinikum Freiburg, 79106 Freiburg (DE)
(72) Erfinder: Hennig, Jürgen, 79100 Freiburg (DE)
(74) Vertreter: KOHLER SCHMID + PARTNER

(57) **Zusammenfassung**

Ein Verfahren der Kernspinresonanz (=NMR)-Spektroskopie oder Tomographie, bei welchem auf ein Spinensemble ein Folge von zeitlich gegeneinander versetzten Hochfrequenz (=HF)-Impulsen im Sinne eines CPMG-Multiechoexperimentes angewendet wird und bei welchem die nach einem initialen Anregungsimpuls erzeugte Magnetisierung in oder nahe an den statischen pseudo steady state zu dem zunächst angewendeten Refokussierungsflipwinkel α1 überführt wird, ist dadurch gekennzeichnet, dass die Magnetisierung durch allmähliche Veränderung des Refokussierungsflipwinkel in aufeinanderfolgenden Refokussierungsintervallen in oder nahe des statischen pseudo steady state zum jeweils verwendeten Refokussierungspuls mit Refokussierungsflipwinkel αₙ überführt wird, so dass die so erzeugte Echoamplitude des n-ten Echos den durch den jeweiligen Refokussierungspuls mit Refokussierungsflipwinkel αₙ entsprechenden maximal möglichen Wert annähert. Dadurch kann die zur Anregung der Kernspins erforderliche HF-Energie deutlich reduziert werden, ohne dass Verluste in der Signalstärke hingenommen werden müssen.

## Beschreibung

Die Erfindung betrifft ein Verfahren der Kernspinresonanz (=NMR)-Spektroskopie oder Tomographie, bei welchem auf ein Spinensemble ein Folge von zeitlich gegeneinander versetzten Hochfrequenz (=HF)-Impulsen im Sinne eines CPMG-Multiechoexperimentes angewendet wird und bei welchem die nach einem initialen Anregungsimpuls erzeugte Magnetisierung in oder nahe an den statischen pseudo steady state zu dem zunächst angewendeten Refokussierungsflipwinkel α1 überführt wird.

Ein solches Verfahren ist bekannt aus Hahn E L, Spin Echoes, Phys.Rev. 80:580-594 (1950) (=Referenz [1]).

Die Messung von Kernresonanzsignalen erfolgt häufig mittels des Spin-Echo Verfahrens [1]. Hierbei wird die angeregte Magnetisierung nach einer Periode te/2 durch einen Refokussierungspuls invertiert und es kommt nach einer weiteren Zeit te/2 zur Bildung eines Spin-Echos. Zum Zeitpunkt des Spin-Echos werden auf die Spins einwirkende Effekte wie chemische Verschiebung, Suszeptibilität, Feldinhomogenität refokussiert, so dass sämtliche Spins bezüglich dieser Effekte eine kohärente Signalphase aufweisen.

Das Signalmaximum wird dabei erreicht, wenn der Flipwinkel des Refokussierungspulses exakt 180° beträgt. Ein solcher idealer Flipwinkel ist in der Praxis immer nur annähernd realisierbar, so dass sich insbesondere bei Verfahren, welche auf der Bildung vieler Spin-Echos beruhen, Signalverluste auf Grund der Abweichung des Flipwinkels der Refokussierungspulse von 180° ergeben. Eine solche Abweichung kann entweder durch technische Gegebenheiten auftreten oder aber auch absichtlich erfolgen, z.B. bei Anwendungen am Menschen zur Einhaltung von Grenzwerten für die abgestrahlte Hochfrequenzenergie (SAR = specific absorption rate).

In der Literatur wurde eine Reihe von Maßnahmen vorgeschlagen, mit welchen die entsprechenden Signalverluste begrenzt werden können. Dies ist zum einen das sogenannte Carr-Purrcell-Meiboom-Gill Verfahren [2], bei welchem durch entsprechende Verschiebung der Signalphase zwischen Anregungs- und Refokussierungspulsen eine teilweise Selbstkompensation der Refokussierungspulse bewirkt wird.

Es konnte gezeigt werden, dass mit einer solchen Sequenz bei langen Echozügen selbst bei kleinen Refokussierungsflipwinkeln hohe Echoamplituden erzielt werden können [3].

Bei Verwendung eines [4] oder mehrerer [5,6] unterschiedlicher Flipwinkel über die ersten Refokussierungsperioden des Multiechozuges lässt sich die Echoamplitude noch weiter steigern.

Alle diese Verfahren basieren auf der Tatsache, dass die Magnetisierung durch Anwendung einer Folge äquidistanter Pulse P(α,φ) mit identischer Amplitude α und Phase φ in einen sogenannten pseudo steady state überführt wird, wobei gezeigt werden konnte [7], dass für jedes α,φ eine unendliche Vielfalt solcher pseudo steady states existiert. Der Begriff pseudo steady state rührt dabei daher, dass eine konstante Signalamplitude nur bei Vernachlässigung von Relaxationseffekten erreicht wird.

Die in den Referenzen [4]-[6] beschriebenen Modifikationen haben daher zum Ziel, die Magnetisierung möglichst nahe an den pseudo steady state mit maximaler Amplitude heranzuführen, welcher im folgenden als PSS0 bezeichnet wird. Neben der Maximierung der Signalintensität werden die bei Verwendung durchgängig konstanter Flipwinkel auftretenden Signalmodulationen vermieden.

Gemeinsames Merkmal aller dieser Verfahren ist es daher, die durch den anfänglichen Anregungspuls erzeugte reine kohärente Magnetisierung M(x,y) möglichst kontinuierlich in oder zumindest nahe PSS0 überzuführen und PSS0 dann durch weitere Anwendung von Pulsen mit konstantem α,φ beizubehalten.

Aufgabe der vorliegenden Erfindung ist es demgegenüber, ein Verfahren der eingangs beschriebenen Art so zu verbessern, dass die zur Anregung der Kernspins erforderliche HF-Energie deutlich reduziert werden kann, ohne dass Verluste in der Signalstärke hingenommen werden müssen.

Erfindungsgemäß wird diese Aufgabe auf überraschend einfache, aber wirkungsvolle Art und Weise dadurch gelöst, dass die Magnetisierung durch allmähliche Veränderung des Refokussierungsflipwinkel in aufeinanderfolgenden Refokussierungs-intervallen in oder nahe des statischen pseudo steady state zum jeweils verwendeten Refokussierungspuls mit Refokussierungsflipwinkel αₙ überführt wird, so dass die so erzeugte Echoamplitude des n-ten Echos den durch den jeweiligen Refokussierungspuls mit Refokussierungsflipwinkel αₙ entsprechenden maximal möglichen Wert annähert.

Das erfindungsgemäße Verfahren beruht auf der überraschenden Erkenntnis dass die einmal in PSS0 überführte Magnetisierung gegenüber Änderungen von α,φ ein überaus robustes Verhalten zeigt und sich insbesondere ohne weiteres von einem PSS0(α1,φ1) in einen anderen PSS0(α2,φ2) mit unterschiedlichem Flipwinkel und Phase überführen lässt. Die erfindungsgemäßen Modulationen der Refokussierungspulse unter transienter Beibehaltung des zum jeweiligen Puls P(αn,φn) zugehörigen PSS0(αn,φn) wird im Folgenden als TRAPS(= transient pseudo steady state) - Verfahren bezeichnet. TRAPS lässt sich für eine Vielzahl von Anwendungen einsetzen, vor allem zur Reduktion der Hochfrequenzbelastung bei langen Echozügen ohne Signalverlust.

Bezüglich dieses Einsatzzweckes ist TRAPS komplementär zum sogenannten Hyperecho-Verfahren [8], bei welchem die volle Magnetisierung durch entsprechende Symmetrisierung der Sequenz um einen zentralen Refokussierungspuls mit 180° Flipwinkel gewonnen wird. Im Unterschied zu TRAPS wird durch den Hyperecho-Mechanismus der pseudo steady state wieder in die ursprüngliche kohärente Magnetisierung überführt, TRAPS benötigt daher auch keinen zentralen 180°-Puls. Beide Techniken sind daher komplementär und lassen sich für eine Reihe von bevorzugten Anwendungen auch sinnvoll kombinieren.

Besonders bevorzugt ist eine Variante des erfindungsgemäßen Verfahrens, bei der die Multiechosequenz durch Verwendung entsprechender zeitlich veränderlicher Magnetfelder im Sinne eines Verfahrens der NMR-Bildgebung nach dem RARE Verfahren Anwendung findet.

Die Multiecho-Erzeugung dürfte ein Hauptanwendungsgebiet des erfindungsgemäßen Verfahrens werden, da hier die Vorteile der Erfindung besonders wirkungsvoll zur Geltung kommen. Bislang waren Einschränkungen des RARE Verfahrens im Hochfeldbereich sowie bei schnellen Anwendungen hinzunehmen, weil hier die erforderliche HF-Anregungsenergie einen begrenzenden Faktor darstellte. Mit Hilfe der Erfindung sind hier ganz erhebliche Erweiterungen möglich geworden.

Bei einer vorteilhaften Weiterbildung der oben beschriebenen Verfahrensvariante wird die Phasenkodierung der einzelnen Echos so durchgeführt, dass die Signale mit niedriger Phasenkodierung Echos mit hoher Signalintensität zugeordnet werden. Damit lassen sich bequem die jeweils gewünschten Bildkontraste anwählen.

Mit einer einzigen Anregung und einem sehr langen Echozug kann bei einer weiteren Verfahrensvariante ein vollständiges Bild dadurch erzeugt werden, dass die Datenaufnahme nach dem Prinzip des HASTE-Experimentes durchgeführt wird, bei welchem die Signale mit niedriger Phasenkodierung in den ersten wenigen Echos aufgenommen werden und die Flipwinkel der Refokussierungspulse anschließend zur Reduktion der Hochfrequenzenergie auf einen niedrigen Wert überführt werden. Hierdurch sind sehr schnelle Aufnahmen möglich.

Besonders bevorzugt ist auch eine Variante des erfindungsgemäßen Verfahrens, bei der durch mehrfache Modulationsperioden der Refokussierungsflipwinkel mehrere Intensitätsmaxima erzeugt und zur Rekonstruktion mehrerer Bilder mit unterschiedlichen Kontrasten verwendet werden. Auf diese Weise können in einer Aufnahme mehrere Bilder mit unterschiedlichen Kontrasten erzeugt werden.

Eine weitere besonders vorteilhafte Ausführungsform des erfindungsgemäßen Verfahrens zeichnet sich dadurch aus, dass ein weiterer Refokussierungspuls mit einem Flipwinkel von 90°+α/2 in bezug auf den vorangegangenen Puls angewendet wird, so dass es zur nahezu vollständigen Refokussierung der Magnetisierung kommt. Mit einem einzigen HF-Impuls werden hierbei weitere kohärente NMR-Signale erzeugt und eine schnelle Refokussierung der Signale ermöglicht.

Bei einer vorteilhaften Weiterbildung dieser Verfahrensvariante wird die nahezu vollständig refokussierte Magnetisierung durch Anwendung eines +90°-Pulses in -z-Magnetisierung bzw. durch Anwendung eines -90°-Pulses in +z-Magnetisierung überführt (Flip back). Dadurch wird eine Magnetisierung in der Nähe des thermischen Gleichgewichts erreicht, so dass nach Beendigung eines Anregungszyklus in sehr kurzer zeitlicher Folge Wiederholungszyklen mit weiteren Anregungen ermöglicht werden, wodurch die Bilderzeugung besonders bei der Aufnahme vieler Bilder besonders schnell wird.

Bei einer alternativen Variante des erfindungsgemäßen Verfahren schließlich wird eine Multiechosequenz zunächst über die ersten n Refokussierungsperioden durchgeführt und anschließend die Rückkehr in eine vollständige Magnetisierungskohärenz nach dem Prinzip der Hyperechobildung bewirkt. Diese Verfahrensvariante ermöglicht besonders starke Bildkontraste, allerdings um den Preis einer verglichen mit der oben beschriebenen Verfahrensvariante erheblich niedrigeren Wiederholungsrate der Anregungszyklen, da nach jeder Anregung eine relativ lange Zeitperiode bis zur ausreichenden Thermalisierung der Kernspins abgewartet werden muss.

Weitere Vorteile der Erfindung ergeben sich aus der Beschreibung und der Zeichnung. Ebenso können die vorstehend genannten und die noch weiter aufgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert.

### Im Einzelnen zeigen die Abbildungen Folgendes:

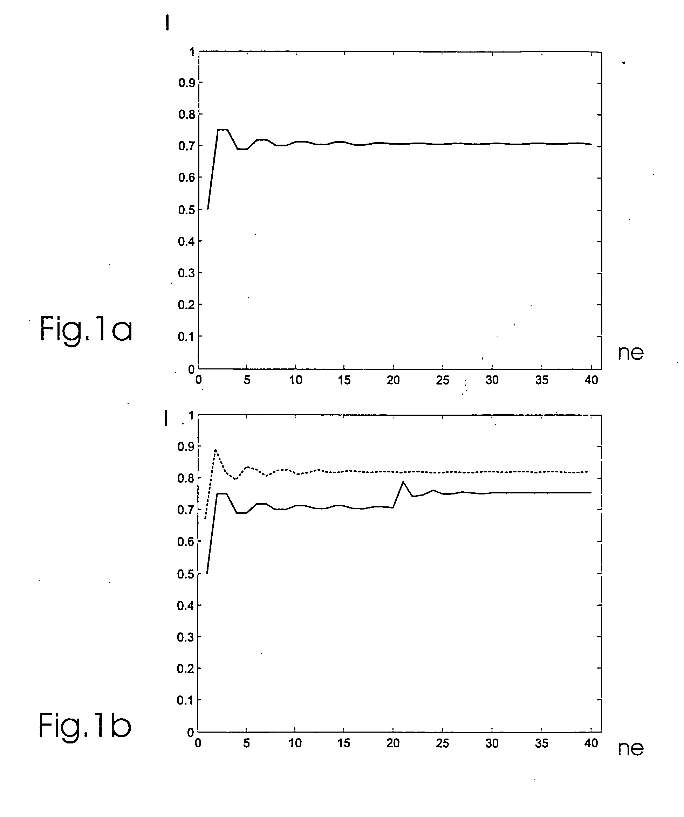

Fig. 1a: Signalintensität 1 eines Multiechoexperimentes mit konstantem Refokussierungsflipwinkel von 90° als Funktion der Echonummer ne. Fig. 1b: Signalintensität eines Multiechoexperimentes mit konstantem Refokussierungsflipwinkel von 90° über die ersten 20 Echos mit nachfolgend konstantem Refokussierungsflipwinkel von 110° in Echo 21-40. Die gepunktete Linie zeigt die Intensitäten eines Experimentes mit durchgängigem konstanten Refokussierungsflipwinkel von 110°.

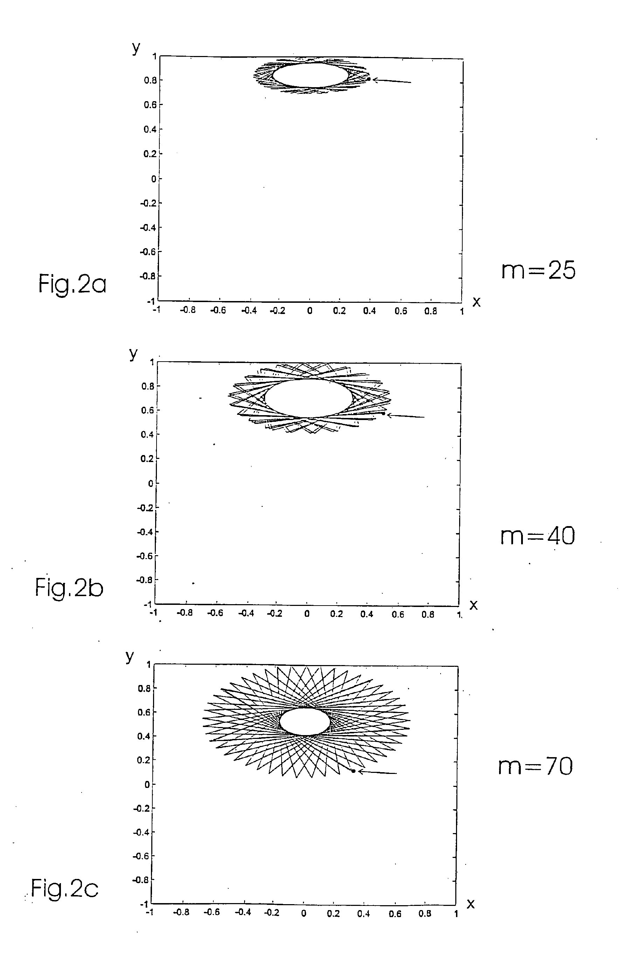

Fig.2a-c: Position von Magnetisierungen, welche in einem Multiechoexperiment mit konstantem RFP von 90° zwischen aufeinanderfolgenden Refokussierungspulsen eine bestimmte konstante Dephasierung erfahren (sogenannte Isochromaten) in der transversalen x-y-Ebene als Funktion der Dephasierung. Der durch einen Pfeil gekennzeichnete schwarze Punkt gibt jeweils die Lage der Magnetisierung im ersten Echo wieder. Die Dephasierung der jeweiligen Isochromaten zwischen aufeinanderfolgenden Refokussierungspulsen beträgt dabei 50°(Fig.2a), 80°(Fig.2b) und 140°(Fig.2c).

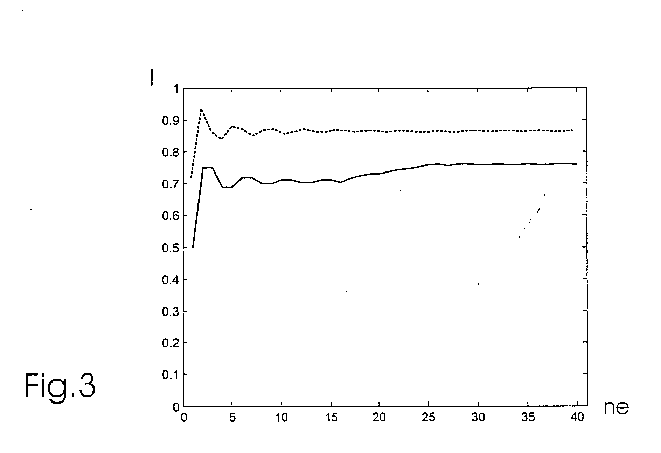

Fig. 3: Signalintensität I eines Multiechoexperimentes mit konstantem Refokussierungsflipwinkel von 90° über die ersten 15 Echos mit nachfolgend linearer Änderung des Flipwinkels bei zur Erreichung eines Refokussierungsflipwinkel von 110° vor dem 25.ten Echo mit nachfolgendem konstantem Refokussierungsflipwinkel von 110° in Echo 26-40. Die gepunktete Linie zeigt die Intensitäten eines Experimentes mit durchgängigem konstanten Refokussierungsflipwinkel von 110°.

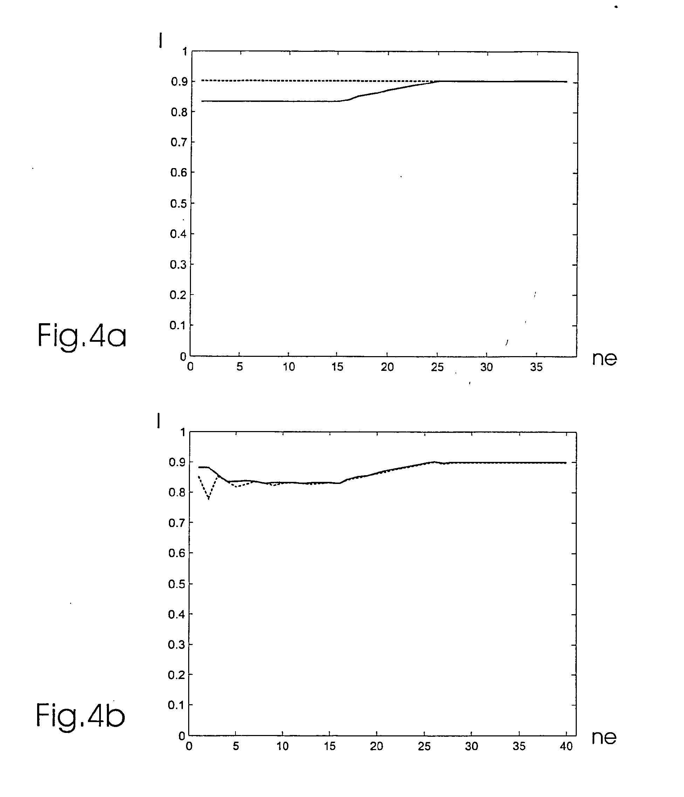

Fig.4a: Signalintensität I eines Multiechoexperimentes mit identischen Messbedingungen wie in Fig.3, jedoch nach Präparation der Magnetisierung in den statischen pseudo steady state. Die Intensität bleibt während der initialen 15 Pulse konstant und geht dann nach Übergang auf 110° in einen Wert über, welcher dem des statischen pseudo steady state für 110° entspricht (gepunktete Linie).

Fig.4b: entsprechend Fig.3 und 4a, jedoch nach Präparation der Magnetisierung durch einen initialen 90°+ α/2=135°-Puls (gepunktete Linie) sowie durch eine initiale Folge von empirisch optimierten Flipwinkeln (139.5, 107.5, 99, 94, 92, 91, 90....) zur besseren Approximation an den statischen pseudo steady state (durchgezogene Linie).

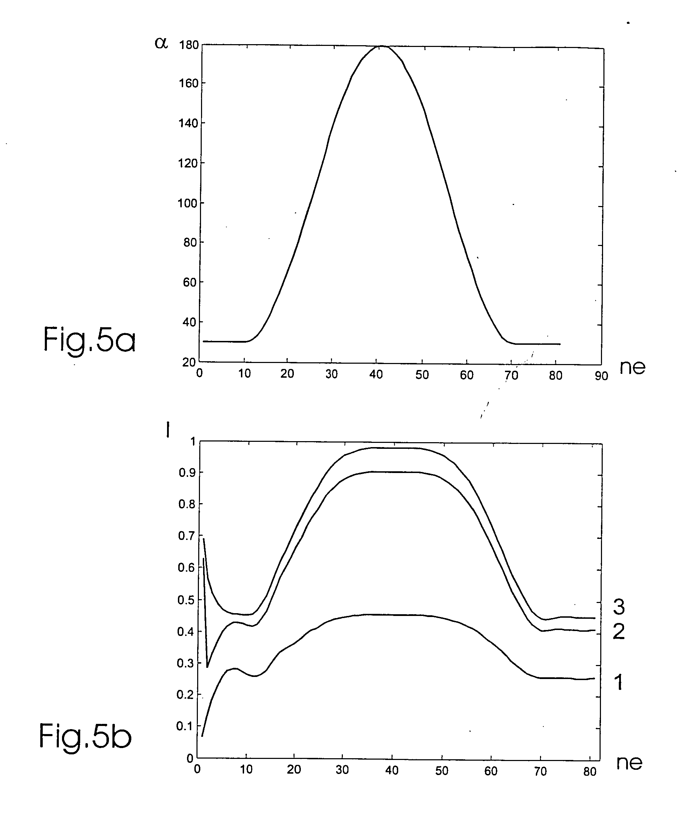

Fig.5: Multiechoexperiment mit einer sinusoidale Variation der Refokussierungsflipwinkel entlang des Echozugs (Fig.5a). Die Signalintensitäten I bei direkter Anwendung der in Fig.5a gezeigten Flipwinkel ergeben einen suboptimalen Verlauf (1), welcher durch Präparation mit einem 135°-Puls (2) oder den oben angegebenen optimierten Flipwinkeln (3) drastisch verbessert wird.

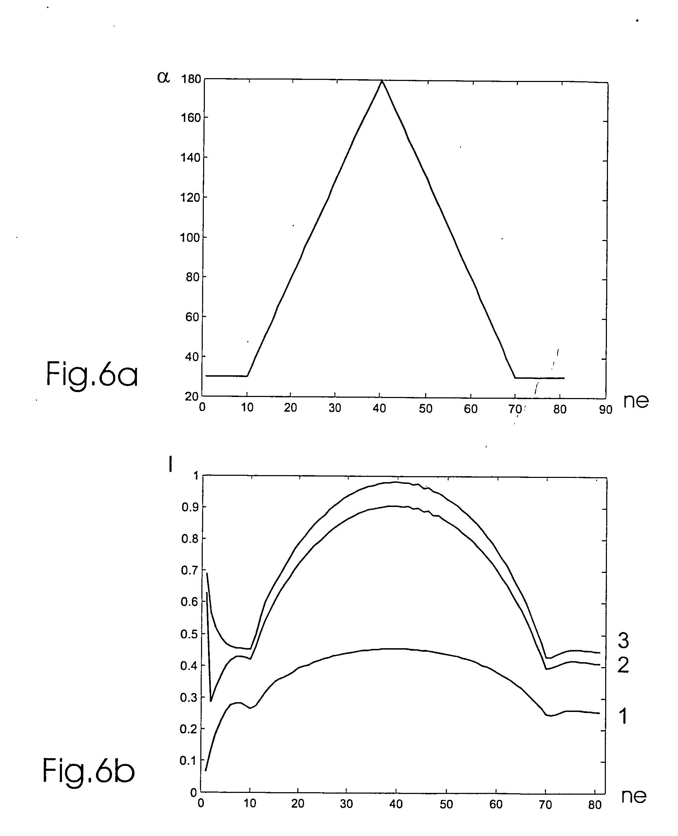

Fig.6: Wie Fig.5, jedoch mit einer linearen, sägezahnförmigen Variation der Refokussierungsflipwinkel (Fig.6a).

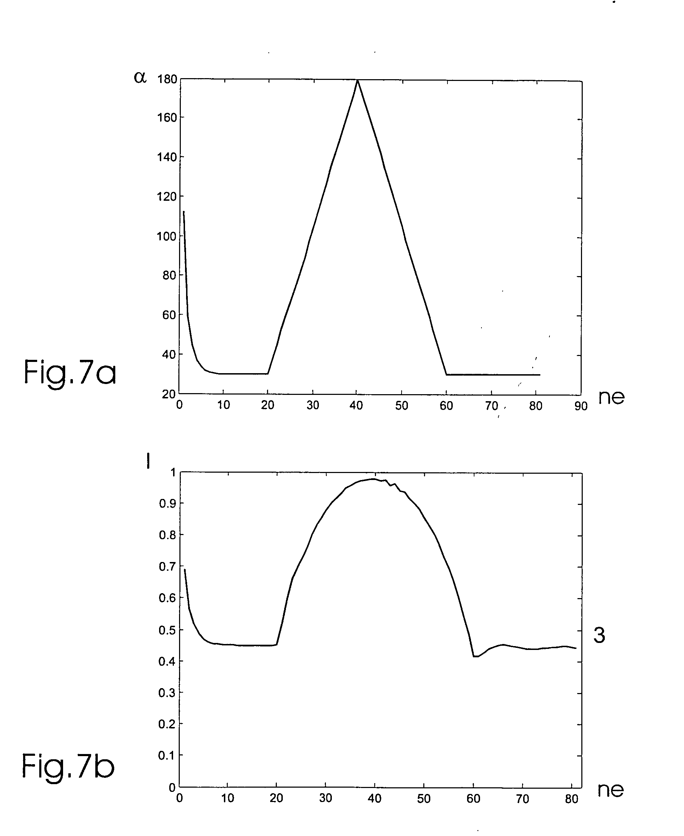

Fig.7: Wie Fig.5, jedoch mit einer steileren Variation der Refokussierungsflipwinkel.

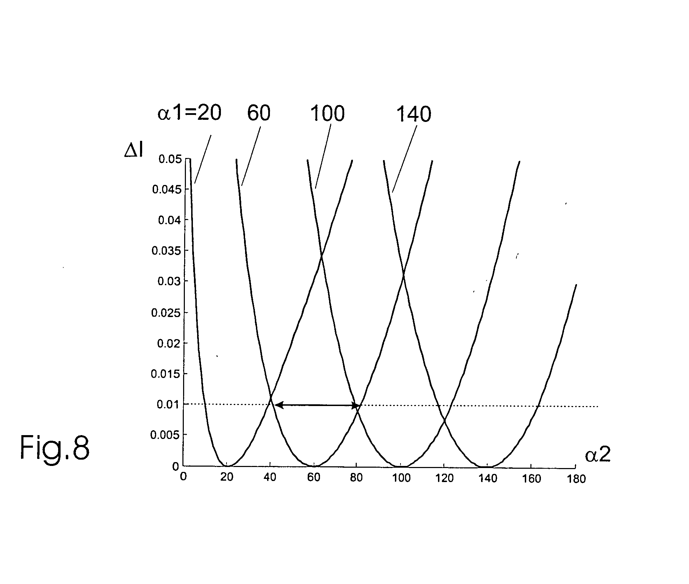

Fig.8: relativer Signalverlust ΔI gegenüber der dem Flipwinkel α2 entsprechenden maximal möglichen Signalamplitude für einen Sprung aus dem statischen pseudo steady state von α1 in eine kontinuierliche Folge von Pulsen mit α2 als Funktion von α2 für α1= 20°, 60°, 100° und 140°.

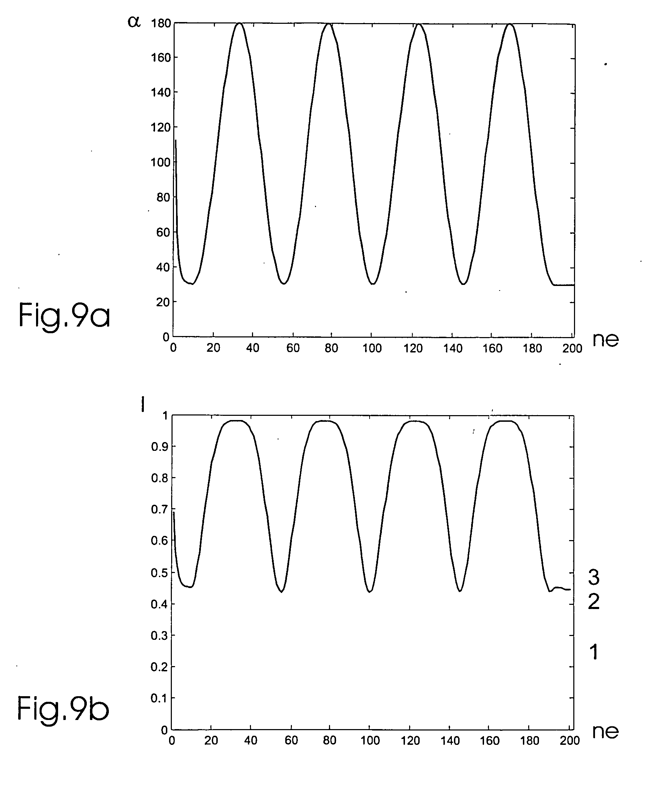

Fig.9a,b: Wie Figuren 5 bis 7, jedoch mit mehrfachem Übergang von niedrigen zu hohen Flipwinkeln.

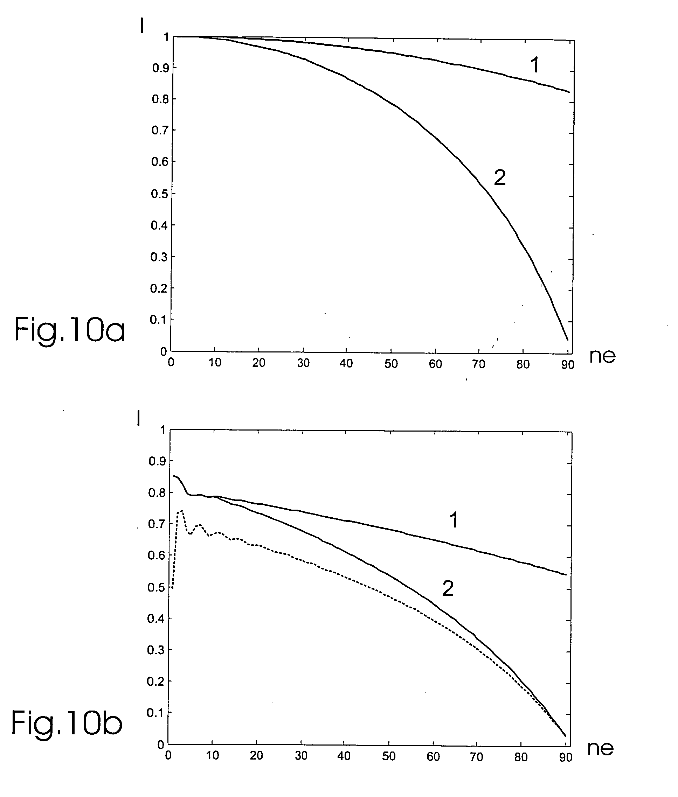

Fig.10a: Signalintensität I eines Multiechoexperimentes mit initialem Refokussierungsflipwinkel 180°, welcher über 90 Echos linear auf 90° (1) bzw. 0° (2) reduziert wird.

Fig.10b: Signalintensität I eines Multiechoexperimentes mit initialem Refokussierungsflipwinkel 90°, welcher über 90 Echos linear auf 45° (1) bzw. 0° (2) reduziert wird mit initialen Flipwinkeln (139.5°, 107.5°, 99°, 94°, 92°, 91°, 90°....) entsprechend Fig.4b. Die gepunktete Linie gibt die Signalintensitäten ohne die initiale Präparation in den statischen pseudo steady state an.

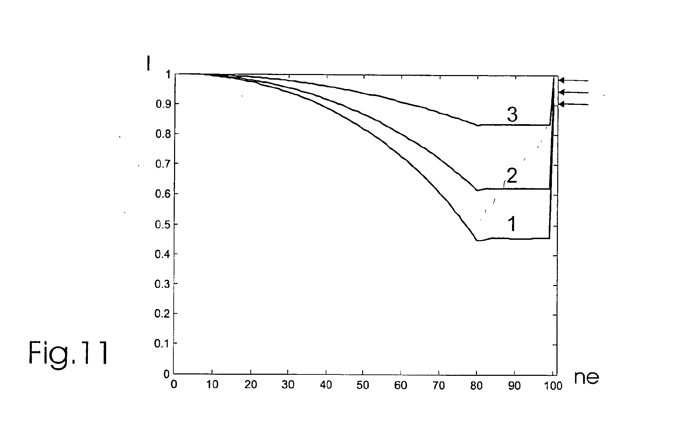

Fig.11: Signalintensitäten für ein Multiecho-Experiment, bei zunächst über die ersten 80 Echos eine lineare Abnahme des Refokussierungsflipwinkels von 180° nach 30° (1), 50° (2) und 90° (3) durchgeführt wird, der abschließende 90°+ α/2-Puls führt zur Ausbildung eines Signals mit einer Intensität von 90% (1), 95% (2) und 99% (3).

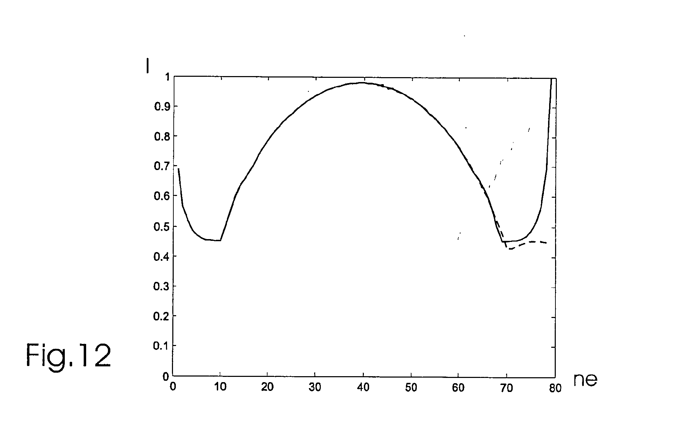

Fig.12: Signalintensitäten für ein Multiecho-Experiment, bei zunächst über die ersten 40 Echos Refokussierungsflipwinkel entsprechend den in Fig.6b verwendeten werden eingesetzt werden, die zweite Hälfte des Echozugs jedoch nach dem Prinzip der Hyperechobildung durchgeführt wird, was zur vollständigen Signalrefokussierung im letzten Echo führt.

Fig.1a zeigt als Beispiel die initialen Signalmodulationen, welche beim Übergang der nach einem initialen Anregungspuls erzeugten kohärenten transversalen Magnetisierung M(x,y) in den pseudo steady state durch Anwendung einer Folge konstanter Refokussierungspulse mit Flipwinkel 90° auftreten. Im folgenden sind Relaxationseffekte ignoriert.

Diese Modulationen gehen nach einigen Refokussierungsperioden in ein konstantes Signal über, jedoch führt die Anwendung eines unterschiedlichen Flipwinkels von 110° zu weiteren Signalmodulationen, bevor sich ein neuer pseudo steady state einstellt (Fig.1b). Das Signalverhalten solcher pseudo steady states ist also gegenüber Änderungen der Refokussierungspulse instabil.

Dem erfindungsgemäßen Verfahren liegt nun die Einsicht zugrunde, dass diese Instabilität eine Folge der Tatsache ist, dass für einen beliebigen pseudo steady state lediglich die Summe aller Magnetisierungen mit jeweils unterschiedlicher Dephasierung zwischen den Refokussierungspulsen konstant wird, während Spins, welche durch eine bestimmte Dephasierung zwischen zwei Refokussierungspulsen charakterisiert sind (sogenannte Isochromaten), eine periodische Bewegung durchführen.

Dies ist in Fig.2 gezeigt. Hier sind für drei Isochromaten die Positionen der Spins zum Echozeitpunkt für eine CPMG-Sequenz mit 90° Refokussierungsflipwinkel dargestellt. Ein Vergleich von Fig.1a und 2 zeigt, dass die in späteren Echos sich ausbildende konstante Amplitude lediglich durch Kohärenzverlust der nach wie vor periodischen Bewegung der Spins zustande kommt.

Diese Einsicht macht die erneut auftretenden Modulationen in Fig.1b verständlich, da nach Wechsel des Refokussierungsflipwinkels erneut einige Echoperioden benötigt werden, um die Isochromaten bei ihrer periodischen Bewegung auf anderen, dem neuen Flipwinkel entsprechenden Trajektorien, wieder in einen neuen pseudo steady state überzuführen.

Die exakte Amplitude der Modulationen ergibt sich aus der Überlagerung der Trajektorien aller an der Echobildung beteiligter Isochromaten. Qualitativ ist verständlich, dass die Modulationen um so stärker sein werden, je größer die mittlere Amplitude der periodischen Bewegung der einzelnen Trajektorien ist.

In der Praxis häufig gravierender als die auftretenden Signalmodulationen ist die Tatsache, dass der für den neuen Refokussierungsflipwinkel erreichte pseudo steady state im allgemeinen eine deutlich geringere Amplitude hat als der pseudo steady state, welcher bei sofortiger Anwendung einer CPMG-Sequenz mit konstantem Flipwinkel erreicht wird (s.Fig.1b).

Aus diesen Überlegungen lässt sich zum einen ableiten, dass die Modulationen klein werden, je kleiner die mittlere Amplitude der periodischen Bewegung der Isochromaten und je geringer die Änderung des Refokussierungsflipwinkels ist.

So ist in Fig.3 gezeigt, dass sich bei einem allmählichen Übergang des Refokussierungsflipwinkels die Signalmodulationen weitgehend vermeiden lassen, allerdings ist auch gezeigt, dass die erreichte Amplitude nach wie vor deutlich unter dem Wert bleibt, welcher bei durchgängiger Anwendung des Ziel-Flipwinkels erreichbar wäre.

Diesem Mangel kann nun über eine weitere Betrachtung des pseudo steady states abgeholfen werden. Insbesondere ist aus der Literatur [4-6] bekannt, dass es unter den unendlich vielen pseudo steady states zu einem bestimmten Refokussierungsflipwinkel einen einzigen statischen pseudo steady state PSS0 gibt, bei welchem alle Isochromaten zum Echozeitpunkt zu ihrer jeweiligen Position zurückkehren.

Für diesen statischen pseudo steady state ist also - formal betrachtet - die Amplitude der periodischen Bewegung aller einzelnen Trajektorien gleich null. Beim Wechsel von einem solchen statischen pseudo steady state zu einem anderen kommt es daher zu keinen Signalmodulationen, wichtiger noch, es wird die dem neuen statischen pseudo steady state zugehörige Signalamplitude erreicht. Dies ist in Fig.4 gezeigt.

Ein Vergleich von Fig.1b und Fig.3 mit Fig.4 zeigt die drastische Verbesserung des Signalverhaltens.

In der Praxis ist ein statischer pseudo steady state mit einer endlichen Anzahl von Refokussierungspulsen nicht exakt erreichbar, allerdings gelingt es, mit wenigen Pulsen (in einer für Flipwinkel im Bereich von ca. 30°-180° bereits sehr guten Näherung bereits mit einem einzelnen Puls mit Flipwinkel 90°+α/2 [4]) eine sehr gute Annäherung an PSS0 durchzuführen. Für sehr große Flipwinkel (ca. > 150°) in der Nähe von 180° kann der mit konstantem Flipwinkel erzielte pseudo steady state bereits als eine gute Näherung an den statischen pseudo steady state betrachtet werden.

Entsprechend den dargelegten Überlegungen ist es nun möglich, nach Erreichen einer solchen Annäherung an den statischen pseudo steady state durch sukzessive Änderung der Flipwinkel Refokussierungspulse die Signalamplitude in die Nähe des für den jeweiligen Flipwinkel geltenden, dem jeweiligen statischen pseudo steady state entsprechenden Wert heranzufahren.

Insbesondere kann so die Signalamplitude durch Wahl kleiner Flipwinkel zunächst klein gehalten werden, um dann in einem späteren Echo durch Übergang zu größeren Flipwinkeln höhere Intensitäten zu erzielen und vice versa.

In Fig.5 ist dies für einen Anfangsflipwinkel von 30° gezeigt, welcher vom 11.-40. Echo zunächst sinusoidal auf 180° erhöht, und dann symmetrisch wieder auf 30° erniedrigt wird. Die Flipwinkel sind in Fig.5a dargestellt, Fig.5b zeigt die resultierenden Echointensitäten. Bei konstantem Anfangsflipwinkel über die ersten 10 Echos ergibt sich dabei ein suboptimaler Intensitätsverlauf, eine Initiierung mit einem ersten Flipwinkel von 105° ergibt bereits eine drastische Verbesserung, eine verbesserte Annäherung an den statischen pseudo steady state über die ersten 5 Flipwinkel führt zu einer weiteren Signalverbesserung, insbesondere wird im 40. Echo die dem dortigen Flipwinkel von 180° zugeordnete Maximalintensität von 1 in sehr guter Näherung erreicht.

Fig.6 zeigt, dass bereits eine lineare Änderung der Flipwinkel ein in der Praxis sehr gutes Ergebnis bringt, wenn auch durch den abrupten Wechsel nach dem Rückgang auf 30° im 70.Echo die nachfolgenden Intensitäten ein leichtes Unterschwingen zeigen.

Die Abweichung ΔI der beobachteten Signalintensität von dem dem jeweiligen Flipwinkel zugeordneten maximal möglichen Signal hängt - wie aus den Figuren 1 bis 3 leicht nachvollziehbar - von der Schnelligkeit der Änderung des Flipwinkels ab.

Ein Vergleich von Fig.6 und Fig.7 zeigt jedoch, dass auch ein steilerer Übergang der Flipwinkel immer noch einen sehr guten Intensitätsverlauf zeigt. ΔI hängt dabei nicht nur von der Sprunghöhe ab, sondern auch vom expliziten Anfangs- und Endwert.

In Fig.8 ist ΔI für verschiedene Sprünge von einem Anfangsflipwinkel α1 zu einem Endflipwinkel α2 gezeigt. Insbesondere ist dargestellt, dass ΔI über einen weiten Bereich von α1 und α2 kleiner als 1% ist, solange der Betrag der Flipwinkeldifferenz |α1 - α2| kleiner als 20° ist. Für größere Flipwinkeldifferenzen wächst ΔI sehr schnell und nichtlinear. Auf Grund dieses nichtlinearen Signalverhaltens ist eine Abschätzung des Gesamtverlustes durch Addition der Fehler von diskreten Sprüngen nur annäherungsweise richtig und daher nur als Anhaltspunkt für die Planung der für eine bestimmte Implementierung zu verwendenden Flipwinkel zu verstehen. Allerdings kann gefolgert werden, dass der Fehler bei einem Übergang von α1 nach α2 in mehreren Stufen immer kleiner ist als der Fehler beim direkten Übergang nach Fig.8.

Für die praktische Implementierung kann man daher davon ausgehen, dass - wie auch in den Figuren 4 bis 7 gezeigt - bei Verwendung einer Schritthöhe Δα zwischen aufeinanderfolgenden Pulsen von Δα < 20° gute Ergebnisse erzielt werden können.

Fig.9 zeigt, dass ein kontinuierlicher Übergang von niedrigen zu hohen Signalintensitäten auch durch entsprechende mehrfache Erhöhung und Erniedrigung der Flipwinkel ohne weiteren Signalverlust realisierbar ist. Fig.10 illustriert Anwendungen, bei welchen der Flipwinkel von einem anfänglich hohen Wert monoton erniedrigt wird.

Fig.10a zeigt den Signalverlauf bei linearem Übergang von 180° auf 90° (1) und von 180° auf 0° (2). Im ersten Fall wird die SAR auf 58% erniedrigt, im zweiten bereits auf 33%.

Weitere Reduktionen sind möglich, wenn auch der initiale Flipwinkel reduziert wird. So zeigt Fig.10b die entsprechenden Signalverläufe bei Reduktion von initial 90° auf 45° (1) und von 90° auf 0° (2), wobei die ersten fünf Refokussierungspulse entsprechend den in Fig.4 gemachten Angaben zur besseren Annäherung an einen statischen pseudo steady state gewählt wurden (α = 139.5, 107.5, 99, 94, 92, 91, 90....). Hier beträgt die Hochfrequenzleistung 13% (1) bzw. 8% (2), d.h. eine Reduktion um ca. einen Faktor 10 bei nur geringem Signalverlust in den initialen Echos.

Für die in Fig.10a gezeigten Kurven ist keine spezielle initiale Präparation nötig, da der statische pseudo steady state für den initialen 180°-Puls direkt und exakt erreicht wird.

Schließlich soll noch gezeigt werden, dass es auch möglich ist, unter speziellen Rahmenbedingungen auch mit Δα > 20° eine hohe Signalintensität wiederherzustellen. Eine Möglichkeit, welche sich insbesondere nach Absinken der Signalintensität nach Anwendung einer der in den Figuren 4 bis 7 beispielhaft gezeigten Implementierungen zur schnellen Wiederherstellung des Signals eignet, folgt aus der bereits mehrfach erwähnten Erkenntnis, dass die volle Signalintensität sich formal als statischer pseudo steady state zum Flipwinkel 180° betrachten lässt und der Tatsache, dass die Verteilung der Magnetisierungen im statischen pseudo steady state nach Referenz [4] dadurch gekennzeichnet ist, dass zum Zeitpunkt der Refokussierungspulse alle Isochromaten in einer gegen die aus der z-Achse und der Richtung des B1-Feldes der Refokussierungspulse gebildeten Ebene um α/2 gekippt erscheinen, was einer Kippung um 90°+ α/2 gegenüber der transversalen Ebene entspricht [4].

Hieraus folgt, dass die Anwendung eines 90°+ α/2 Pulses die Magnetisierungen aus dem statischen pseudo steady state vollständig in die transversale Ebene zurückführt und zur Ausbildung eines Signals mit einer Intensität von nahezu 100% führt. Formal entspricht dies einem zweistufigen linearen Übergang von α nach 180° über den Mittelwert α + (180°-α )/2 = 90°+ α/2.

Wie in Fig.11 gezeigt, werden hierdurch Magnetisierungen, welche durch eine der in der Literatur bekannten Maßnahmen oder auch durch allmählichen Übergang nach den hier beschriebenen Prinzipien in oder nahe den statischen pseudo steady state überführt wurden, nahezu vollständig refokussiert. In Fig.11 wurde zunächst ein linearer Übergang der Refokussierungsflipwinkel von 180° auf α=30° (1), 50° (2) und 90° (3) über die ersten 80 Echos durchgeführt, der abschließende 90°+ α/2-Puls führt zur Ausbildung eines Signals mit einer Intensität von 90% (1), 95% (2) und 99% (3).

Alle diese Verfahren werden - wie eingangs erwähnt - als TRAPS(=**tra**nsition between **p**seudo **s**teady state)-Verfahren bezeichnet. Besonders vorteilhafte Anwendungen findet TRAPS in der kernspintomographischen Bildgebung in Multiechoverfahren nach dem Prinzip der RARE-Sequenz. Es ist bekannt, dass der Kontrast und das Signal-zu-Rausch Verhältnis (SNR) eines nach diesem Verfahren aufgenommenen Bildes im wesentlichen von der Intensität derjenigen Echos bestimmt wird, welche eine geringe Phasenkodierung aufweisen entsprechend der Signale in der Mitte des k-Raums. Wendet man TRAPS so an, dass für diese Signale die maximale Signalintensität erreicht (bzw. angenähert) wird, so werden die entsprechenden Bilder ein nahezu identisches SNR im Vergleich zu der Datenaufnahme mit einem durchgängig konstanten Flipwinkel von 180° erzeugen, wobei die TRAPS-Aufnahme auf Grund der weitgehend niedrigen Flipwinkel nur einen Bruchteil der Hochfrequenzleistung benötigt und damit die Hochfrequenzabsorption (=SAR) des Patienten drastisch reduziert wird.

So benötigt eine Implementierung mit den in Fig.5 verwendeten Flipwinkel nur 33% der HF-Leistung, die lineare Veränderung der Flipwinkel entsprechend Fig.6 entspricht 30% der Leistung des Vergleichsexperiments mit 180° Flipwinkeln. Vor allem für die Anwendung bei Feldstärken von 1,5T und ganz besondere bei noch höheren Feldern ermöglicht TRAPS so die schnelle Aufnahme von Bildern, für welche die dem Patienten zumutbare zulässige SAR bei konventioneller Anwendung ansonsten überschritten würde.

Eine praktische Implementierung, bei welcher die Signale entsprechend Fig.9 mehrfach auf einen möglichst hohen Wert gebracht werden, ist durch die sogenannten Multikontrastsequenzen mit view sharing gegeben. Bei dieser Technik wird ein kleiner Teil der Datenmatrix in der Mitte des k-Raums mehrfach und zu unterschiedlichen Echozeiten aufgenommen, die zur Bildrekonstruktion notwendigen fehlenden Teile der k-Raumdaten werden nur einmal aufgenommen und mit den jeweiligen Daten zur Bildrekonstruktion mehrerer Bilder kombiniert.

Die in Fig.11 gezeigte Möglichkeit einer schnellen Rückkehr zu einer (nahezu) vollständigen Herstellung der Signalkohärenz lässt sich besonders dann vorteilhaft einsetzen, wenn die so erzeugte Magnetisierung durch einen Puls mit Flipwinkel -90° im Sinne eines Flipback-Experimentes wieder in z-Magnetisierung überzuführen, welche dann sehr nahe am thermischen Gleichgewichtswert liegt, so dass eine schnelle Wiederholung der Aufnahme ohne nennenswerte Signalsättigung möglich wird [9].

Komplementär lässt sich durch Anwendung eines Pulses mit Flipwinkel 90° die nahezu kohärente Magnetisierung in die -z-Richtung verlagern, was einer Signalinversion entspricht und damit zur Aufnahme von Bildern mit entsprechendem T1-Kontrast Anwendung finden kann.

Gegenüber dem kürzlich veröffentlichten Hyperecho-Verfahren [8], welches ebenfalls eine Reduzierung der SAR ohne Signalverlust erlaubt und bei welchem eine Rückkehr zur vollständigen Signalamplitude durch Ausnutzung von Symmetrieeigenschaften der Spin-Echo Bildung erzeugt wird, unterscheidet sich TRAPS formal dadurch, dass im Gegensatz zur Hyperecho-Bildung die Phase der Refokussierungspulse durchgängig entsprechend der CPMG-Bedingung gewählt werden kann, auch verlangt TRAPS keinen intermediären 180°-Puls zur Rückkehr zur vollen Signalamplitude.

Demgegenüber unterliegt der Hyperecho-Mechanismus keiner Beschränkung bezüglich der Differenz aufeinanderfolgender Flipwinkel und kann damit auch für sehr schnelle Amplitudenvariationen angewendet werden.

Bezüglich der Anwendung in RARE-Sequenzen sind TRAPS und Hyperecho-Verfahren daher als komplementär zu betrachten: Hyperechoes sind dann vorteilhaft, wenn eine schnelle Änderung der Flipwinkel erwünscht ist, in der Praxis ist dies für Multiechosequenzen mit Echozuglängen von bis zu ca. 15-20 der Fall. Für längere Echozüge, bei welchen eine allmähliche Veränderung der Signalintensitäten erwünscht ist, ist jedoch die Implementierung von TRAPS vorteilhaft.

Das Prinzip der Hyperecho-Bildung lässt sich auch auf TRAPS-Sequenzen anwenden. So zeigt etwa Fig.12 ein Beispiel, bei welchem die Flipwinkel zunächst über die ersten 40 Refckussierungsperioden entsprechend den für Fig.6b (3) gezeigten Werten angewendet werden.

Nach dem 180°-Puls, welcher vor dem 40ten Echo angewendet wird, werden dann jedoch in den nachfolgenden Echoperioden die Pulse entsprechend dem Prinzip der Hyperechobildung gewählt, d.h. die Pulsphasen werden invertiert und die Flipwinkel in zeitlich umgekehrter Reihenfolge verwendet. Der Verlauf der Signalintensitäten ist dabei über weite Strecken sehr ähnlich zu dem in Fig.6b gezeigten und hier nochmals gestrichelt wiedergegebenen Werten, allerdings wird bei der Hyperechobildung am Schluss des Echozugs ein vollständig refokussiertes Signal gebildet, was sich wiederum mittels Flipback-Pulsen in z-Magnetisierung überführen lässt.

## Patentansprüche

1. Verfahren der Kernspinresonanz (=NMR)-Spektroskopie oder Tomographie, bei welchem auf ein Spinensemble ein Folge von zeitlich gegeneinander versetzten Hochfrequenz (=HF)-lmpulsen im Sinne eines CPMG-Multiechoexperimentes angewendet wird und bei welchem die nach einem initialen Anregungsimpuls erzeugte Magnetisierung in oder nahe an den statischen pseudo steady state zu dem zunächst angewendeten Refokussierungsflipwinkel α1 überführt wird,
**dadurch gekennzeichnet,**
**dass** die Magnetisierung durch allmähliche Veränderung des Refokussierungsflipwinkel in aufeinanderfolgenden Refokussierungs-intervallen in oder nahe des statischen pseudo steady state zum jeweils verwendeten Refokussierungspuls mit Refokussierungsflipwinkel αₙ überführt wird, so dass die so erzeugte Echoamplitude des n-ten Echos den durch den jeweiligen Refokussierungspuls mit Refokussierungsflipwinkel αₙ entsprechenden maximal möglichen Wert annähert.

2. Verfahren nach Anspruch 1, **dadurch gekennzeichnet, dass** die Multiechosequenz durch Verwendung entsprechender zeitlich veränderlicher Magnetfelder im Sinne eines Verfahrens der NMR-Bildgebung nach dem RARE Verfahren Anwendung findet.

3. Verfahren nach Anspruch 2, **dadurch gekennzeichnet, dass** die Phasenkodierung der einzelnen Echos so durchgeführt wird, dass die Signale mit niedriger Phasenkodierung Echos mit hoher Signalintensität zugeordnet werden.

4. Verfahren nach Anspruch 2 oder 3, **dadurch gekennzeichnet, dass** die Datenaufnahme nach dem Prinzip des HASTE-Experimentes durchgeführt wird, bei welchem die Signale mit niedriger Phasenkodierung in den ersten wenigen Echos aufgenommen werden und die Flipwinkel der Refokussierungspulse anschließend zur Reduktion der Hochfrequenzenergie auf einen niedrigen Wert überführt werden.

5. Verfahren nach einem der vorhergehenden Ansprüche, **dadurch gekennzeichnet, dass** durch mehrfache Modulationsperioden der Refokussierungsflipwinkel mehrere Intensitätsmaxima erzeugt und zur Rekonstruktion mehrerer Bilder mit unterschiedlichen Kontrasten verwendet werden.

6. Verfahren nach einem der vorhergehenden Ansprüche, **dadurch gekennzeichnet, dass** ein weiterer Refokussierungspuls mit einem Flipwinkel von 90°+α/2 in Bezug auf den vorangegangenen Puls angewendet wird, so dass es zur nahezu vollständigen Refokussierung der Magnetisierung kommt.

7. Verfahren Anspruch 6, **dadurch gekennzeichnet, dass** die nahezu vollständig refokussierte Magnetisierung durch Anwendung eines +90°-Pulses in -z-Magnetisierung bzw. durch Anwendung eines -90°-Pulses in +z-Magnetisierung überführt wird.

8. Verfahren nach einem der Ansprüche 1 bis 5, **dadurch gekennzeichnet, dass** eine Multiechosequenz zunächst über die ersten n Refokussierungsperioden durchgeführt und anschließend die Rückkehr in eine vollständige Magnetisierungskohärenz nach dem Prinzip der Hyperechobildung bewirkt wird.
